# EUROPEAN PATENT APPLICATION

(11) **EP 4 697 869 A1**
(43) Date of publication of application: **18.02.2026**
(21) Application number: 24867144.8
(22) Date of filing: 08.08.2024
(51) Int. Cl.: H05K 5/02, H04M 1/02

(54) **FOLDABLE DEVICE**

(30) Priority: 21.09.2023 CN 202311228256
(71) Applicant: Huawei Technologies Co., Ltd., Shenzhen, Guangdong 518129 (CN)
(72) Inventor: ZHAO, Yang, Shenzhen, Guangdong 518129 (CN); LI, Changqing, Shenzhen, Guangdong 518129 (CN); DING, Hong, Shenzhen, Guangdong 518129 (CN); LI, Yin, Shenzhen, Guangdong 518129 (CN)
(74) Representative: Thun, Clemens
(86) International application number: PCT/CN2024/110848
(87) International publication number: WO 2025/060727

(57) **Abstract**

Embodiments of this application provide a foldable device and relate to the field of terminal product technologies. The foldable device includes a first mechanical part, a second mechanical part, a third mechanical part, a first hinge mechanism, a second hinge mechanism, and a flexible display. One end of the first mechanical part is rotatably connected to the second mechanical part through the first hinge mechanism, and the other end of the first mechanical part is rotatably connected to the third mechanical part through the second hinge mechanism. The flexible display includes a support layer and a cover layer. The support layer is fastened to a part of the first mechanical part and the second mechanical part, and the cover layer is fastened to the other part of the first mechanical part and the third mechanical part. Alternatively, the second mechanical part and the third mechanical part are separately folded toward different sides of the first mechanical part. In this way, during folding of the foldable device, neither of the support layer and the cover layer is likely to be pressed against or pulled due to displacement superposition, so that a risk of damage to the flexible display can be reduced.

## Description

This application claims priority to Chinese Patent Application No. 202311228256.3, filed with the China National Intellectual Property Administration on September 21, 2023 and entitled "FOLDABLE DEVICE", which is incorporated herein by reference in its entirety.

### TECHNICAL FIELD

Embodiments of this application relate to the field of terminal product technologies, and in particular, to a foldable device.

### BACKGROUND

With development of electronic device technologies such as a smartphone or a tablet computer, to improve user experience, an area of a display of an electronic device becomes increasingly large. However, when the area of the display of the electronic device is large, an overall size of the electronic device is large, and it is inconvenient to carry the electronic device. To make it more convenient to carry an electronic device having a display with a large area, a foldable device, for example, a foldable mobile phone or a foldable computer, with a flexible display emerges. The foldable device may be folded and unfolded. When the foldable device is folded, the foldable device has a small size and is easy to carry. After the foldable device is unfolded, the foldable device has a large-sized display, so that user experience is good.

The foldable device is usually of a dual-fold structure. The foldable device of the dual-fold structure includes a flexible display, two mechanical parts, and a hinge mechanism that enables the two mechanical parts to be rotatably connected. The flexible display is fastened to surfaces of the two mechanical parts.

However, with diversification of user requirements, the foldable device of the dual-fold structure can hardly meet requirements of some users, and a foldable device of a tri-fold structure or a structure with more folds emerges. In the foldable device of the tri-fold structure or the structure with more folds, a risk of damage to a flexible display fastened to surfaces of three mechanical parts is high.

### SUMMARY

Embodiments of this application provide a foldable device, to reduce a risk of damage to a flexible display fastened to surfaces of three mechanical parts.

An aspect of embodiments of this application provides a foldable device, including a housing assembly and a flexible display disposed on a surface of the housing assembly. The flexible display includes a support layer and a cover layer. The support layer is located on a side, facing the housing assembly, of the flexible display. The cover layer is located on a side, facing away from the housing assembly, of the flexible display. The housing assembly includes a first mechanical part, a second mechanical part, a third mechanical part, a first hinge mechanism, and a second hinge mechanism. The first mechanical part includes a first end and a second end that are opposite to each other. The first end is rotatably connected to the second mechanical part through the first hinge mechanism. The second end is rotatably connected to the third mechanical part through the second hinge mechanism. The first mechanical part includes a first side surface. The first side surface is located on a side in a thickness direction of the first mechanical part. The first side surface includes a first region and a second region. The second mechanical part and the first region are fastened to the support layer through a first fastening structure. The third mechanical part and the second region are fastened to the cover layer through a second fastening structure.

According to the foldable device in the foregoing embodiment, when the foldable device switches from an unfolded state to a folded state, a part of the support layer that is opposite to the second mechanical part and a part of the support layer that is opposite to a region between the second mechanical part and the first region do not undergo displacement relative to the housing assembly, and a part of the support layer that is opposite to the third mechanical part and a part of the support layer that is opposite to a region between the third mechanical part and the first region undergo overall displacement toward a same direction. This avoids displacement superposition of the support layer that is caused by a case in which two parts of the support layer undergo displacement toward opposite directions due to rotation of the second mechanical part and the third mechanical part relative to the first mechanical part, and avoids damage to the support layer that is caused by a case in which the support layer is pressed against or pulled due to displacement superposition. When the foldable device switches from the unfolded state to the folded state, a part of the cover layer that is opposite to the third mechanical part and a part of the cover layer that is opposite to a region between the third mechanical part and the second region do not undergo displacement relative to the housing assembly, and a part of the cover layer that is opposite to the second mechanical part and a part of the cover layer that is opposite to a region between the second mechanical part and the second region undergo overall displacement toward a same direction. This avoids displacement superposition of the cover layer that is caused by a case in which two parts of the cover layer undergo displacement toward opposite directions due to rotation of the second mechanical part and the third mechanical part relative to the first mechanical part, and avoids damage to the cover layer that is caused by a case in which the cover layer is pressed against or pulled due to displacement superposition. In this way, a risk of damage to the flexible display can be reduced. In addition, based on a low risk of damage to the flexible display, a limitation on a folding form and a folding mode of a foldable device of a tri-fold structure or a structure with more folds is small.

In a possible implementation, when the foldable device is in the folded state, the second mechanical part and the third mechanical part are located on a same side in the thickness direction of the first mechanical part.

In a possible implementation, when the foldable device is in the folded state, the second mechanical part and the third mechanical part are located on a side in a first direction of the first mechanical part. The first direction is a direction in which the first side surface faces the flexible display along the thickness direction of the first mechanical part.

In a possible implementation, when the foldable device is in the folded state, the second mechanical part and the third mechanical part are located on a side in a second direction of the first mechanical part. The first mechanical part further includes a second side surface opposite to the first side surface. The second direction is a direction in which the second side surface faces away from the flexible display along the thickness direction of the first mechanical part.

In a possible implementation, when the foldable device is in the folded state, the second mechanical part is located on the side in the first direction of the first mechanical part. The second mechanical part includes a third end and a fourth end that are opposite to each other. The first end is rotatably connected to the third end through the first hinge mechanism. One end of the flexible display is located between the third end and the fourth end. When the foldable device is in the unfolded state, a first spacing exists between the cover layer and the fourth end. When the foldable device is in the folded state, a second spacing exists between the cover layer and the fourth end. The first spacing is greater than the second spacing.

In a possible implementation, when the foldable device is in the folded state, the third mechanical part is located on the side in the second direction of the first mechanical part. The third mechanical part includes a fifth end and a sixth end that are opposite to each other. The second end is rotatably connected to the fifth end through the second hinge mechanism. One end of the flexible display is located between the fifth end and the sixth end. When the foldable device is in the unfolded state, a third spacing exists between the support layer and the sixth end. When the foldable device is in the folded state, a fourth spacing exists between the support layer and the sixth end. The third spacing is greater than the fourth spacing.

In a possible implementation, the flexible display further includes a display layer located between the cover layer and the support layer. The cover layer includes a fastening region protruding from an outer edge of the display layer. The second fastening structure is located in the fastening region.

In a possible implementation, the first hinge mechanism is fastened to the support layer through the first fastening structure.

In a possible implementation, the second hinge mechanism is fastened to the cover layer through the second fastening structure.

In a possible implementation, both the first fastening structure and the second fastening structure are bonding structures. The second mechanical part and the first region are bonded and fastened to the support layer through the first fastening structure. The third mechanical part and the second region are bonded and fastened to the cover layer through the second fastening structure.

Another aspect of embodiments of this application provides another foldable device, including a housing assembly and a flexible display disposed on a surface of the housing assembly. The flexible display includes a support layer and a cover layer. The support layer is located on a side, facing the housing assembly, of the flexible display. The cover layer is located on a side, facing away from the housing assembly, of the flexible display. The housing assembly includes a first mechanical part, a second mechanical part, a third mechanical part, a first hinge mechanism, and a second hinge mechanism. The first mechanical part includes a first end and a second end that are opposite to each other. The first end is rotatably connected to the second mechanical part through the first hinge mechanism. The second end is rotatably connected to the third mechanical part through the second hinge mechanism. The first mechanical part includes a first side surface and a second side surface. The first side surface and the second side surface are separately located on two sides in a thickness direction of the first mechanical part. When the foldable device is in a folded state, the second mechanical part is located on a side in a second direction of the first mechanical part, and the third mechanical part is located on a side in a first direction of the first mechanical part. The first direction is a direction in which the first side surface (130) faces the flexible display along the thickness direction of the first mechanical part. The second direction is a direction in which the second side surface faces away from the flexible display along the thickness direction of the first mechanical part. One of the support layer and the cover layer is fastened to the first side surface, the second mechanical part, and the third mechanical part.

According to the foldable device in the foregoing embodiment, one of the support layer and the cover layer that is fastened to the first side surface, the second mechanical part, and the third mechanical part does not undergo displacement relative to the housing assembly, and the one of the support layer and the cover layer that is fastened to the first side surface, the second mechanical part, and the third mechanical part does not have the following problem: Two parts of the layer undergo displacement toward opposite directions, and consequently, the layer is pressed against or pulled, causing damage to the cover layer. Rotation of the second mechanical part and the third mechanical part relative to the first mechanical part enables one of the support layer and the cover layer that is not fastened to the first side surface, the second mechanical part, and the third mechanical part to undergo displacement toward a same direction. To be specific, for the one of the support layer and the cover layer that is not fastened to the first side surface, the second mechanical part, and the third mechanical part, displacement caused by rotation of the second mechanical part relative to the first mechanical part may supplement displacement caused by rotation of the third mechanical part relative to the first mechanical part. In this way, the one of the support layer and the cover layer that is not fastened to the first side surface, the second mechanical part, and the third mechanical part undergoes overall displacement toward one direction, and the one of the support layer and the cover layer that is not fastened to the first side surface, the second mechanical part, and the third mechanical part does not have the following problem: Two parts of the layer undergo displacement toward opposite directions, and consequently, the layer is pressed against or pulled, causing damage to the cover layer. In this way, a risk of damage to the flexible display can be reduced.

In a possible implementation, the first side surface, the second mechanical part, and the third mechanical part are fastened to the support layer through a first fastening structure.

In a possible implementation, at least one of the first hinge mechanism and the second hinge mechanism is fastened to the support layer through the first fastening structure.

In a possible implementation, the third mechanical part includes a fifth end and a sixth end that are opposite to each other, the second end is rotatably connected to the fifth end through the second hinge mechanism, and one end of the flexible display is located between the fifth end and the sixth end. When the foldable device is in an unfolded state, a fifth spacing exists between the cover layer and the sixth end. When the foldable device is in the folded state, a sixth spacing exists between the cover layer and the sixth end. The fifth spacing is greater than the sixth spacing.

In a possible implementation, the first side surface, the second mechanical part, and the third mechanical part are fastened to the cover layer through a second fastening structure.

In a possible implementation, at least one of the first hinge mechanism and the second hinge mechanism is fastened to the cover layer through the second fastening structure.

In a possible implementation, the second mechanical part includes a third end and a fourth end that are opposite to each other, the first end is rotatably connected to the third end through the first hinge mechanism, and one end of the flexible display is located between the third end and the fourth end. When the foldable device is in an unfolded state, a seventh spacing exists between the support layer and the fourth end. When the foldable device is in the folded state, an eighth spacing exists between the support layer and the fourth end. The seventh spacing is greater than the eighth spacing.

In a possible implementation, one of the support layer and the cover layer is bonded and fastened to the first side surface, the second mechanical part, and the third mechanical part through a bonding structure.

### BRIEF DESCRIPTION OF DRAWINGS

FIG. 1 is a diagram of a foldable device in an unfolded state according to an embodiment of this application;
FIG. 2 is a diagram of another foldable device in an unfolded state according to an embodiment of this application;
FIG. 3 is a schematic cross-sectional view of a flexible display of a foldable device according to an embodiment of this application;
FIG. 4 is a diagram of a foldable device according to an implementation;
FIG. 5 is a diagram of a foldable device according to another implementation;
FIG. 6 is a diagram of a foldable device according to still another implementation;
FIG. 7 is a diagram of a foldable device according to still another implementation;
FIG. 8 is a diagram of a first side surface of a foldable device according to an embodiment of this application;
FIG. 9 is a diagram of a foldable device according to an embodiment of this application;
FIG. 10 is a diagram of another foldable device according to an embodiment of this application;
FIG. 11 is a diagram of still another foldable device according to an embodiment of this application;
FIG. 12 is a diagram of still another foldable device according to an embodiment of this application;
FIG. 13 is a diagram of still another foldable device according to an embodiment of this application;
FIG. 14 is a diagram of still another foldable device according to an embodiment of this application;
FIG. 15 is a diagram of still another foldable device according to an embodiment of this application;
FIG. 16 is a diagram of still another foldable device according to an embodiment of this application;
FIG. 17 is a diagram of a cover layer of a foldable device according to an embodiment of this application;
FIG. 18 is a diagram of a joint between a flexible display of a foldable device and a second fastening structure according to an embodiment of this application; and
FIG. 19 is a schematic cross-sectional view of a plane A-A in FIG. 1.

### Reference numerals:

10: housing assembly;
100: first mechanical part; 110: first end; 120: second end; 130: first side surface; 131: first region; 132: second region; 140: second side surface;
200: second mechanical part; 210: third end; 220: fourth end;
300: third mechanical part; 310: fifth end; 320: sixth end;
400: first hinge mechanism;
500: second hinge mechanism;
600: flexible display; 610: support layer; 620: cover layer; 621: display region; 622: fastening region; 630: display layer;
710: first fastening structure; 720: second fastening structure;
L1: first spacing; L2: second spacing; L3: third spacing; L4: fourth spacing; L5: fifth spacing; L6: sixth spacing; L7: seventh spacing; L8: eighth spacing;
x: first direction; y: second direction;
M1: displacement direction of the cover layer; M2: displacement direction of the support layer.

### DESCRIPTION OF EMBODIMENTS

Terms used in implementations of this application are merely intended to describe specific embodiments of this application, but not to limit this application. The following describes implementations of embodiments of this application in detail with reference to the accompanying drawings.

Embodiments of this application provide a foldable device having a folded state and an unfolded state. The foldable device may change a form of the foldable device through folding and unfolding, to meet requirements of a user in different scenarios. For example, when being carried, the foldable device may be folded to reduce a size in a length direction or a width direction of the foldable device; or when being used, the foldable device may be unfolded to increase an area of a display used for displaying or an operation. It should be noted that the foldable device may also be referred to as user equipment (user equipment, UE), a terminal (terminal), or the like.

The foldable device provided in embodiments of this application may include but is not limited to a foldable electronic product such as a mobile phone, a tablet personal computer (tablet personal computer), a laptop computer (laptop computer), a notebook computer, a personal digital assistant (personal digital assistant, PDA), a personal computer, a multimedia player, an e-book reader, a vehicle-mounted device, or a wearable device. The wearable device may include but is not limited to a smartband, a smartwatch, a smart head-mounted display, smart glasses, or the like. In embodiments of this application, an example in which the foldable device is a mobile phone is used for description.

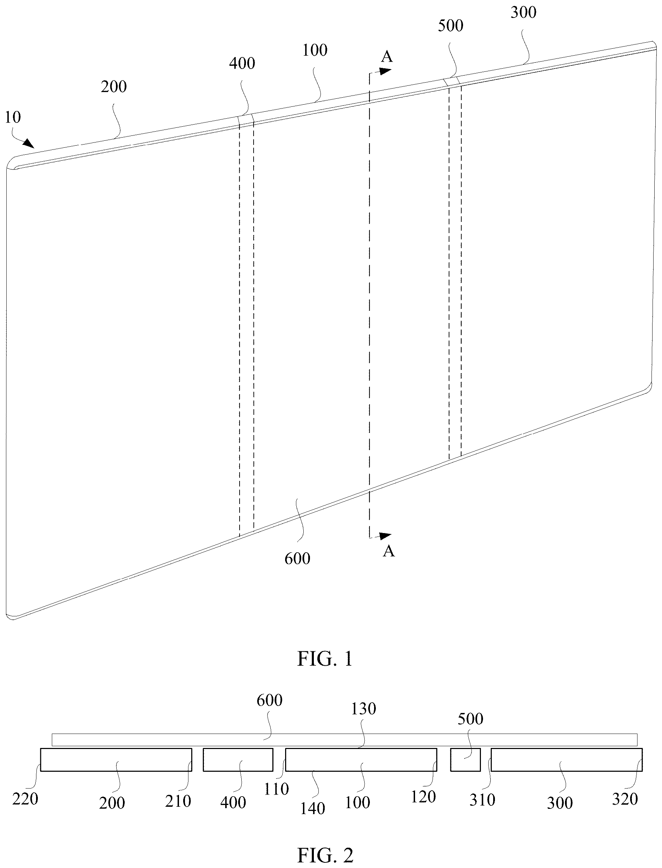

FIG. 1 is a diagram of a foldable device in an unfolded state according to an embodiment of this application.

As shown in FIG. 1, in this embodiment of this application, the foldable device includes a foldable housing assembly 10 and a flexible display 600 disposed on a surface of the housing assembly 10. The housing assembly 10 includes a first mechanical part 100, a second mechanical part 200, a third mechanical part 300, a first hinge mechanism 400, and a second hinge mechanism 500. One end of the first mechanical part 100 is rotatably connected to the second mechanical part 200 through the first hinge mechanism 400, and an end, facing away from the first hinge mechanism 400, of the first mechanical part 100 is rotatably connected to the third mechanical part 300 through the second hinge mechanism 500, so that the foldable device can switch between a folded state and the unfolded state.

When the foldable device is in the unfolded state, the second mechanical part 200 and the first mechanical part 100 rotate until an included angle between the second mechanical part 200 and the first mechanical part 100 is approximately 180°, and the third mechanical part 300 and the first mechanical part 100 rotate until an included angle between the third mechanical part 300 and the first mechanical part 100 is approximately 180°. Persons skilled in the art can understand that the included angle being approximately 180° in this application document may not mean being exact 180° due to a design tolerance or other reasons, and a slight deviation is allowed. For example, the included angle may be 165°, 177°, or 185°.

When the foldable device is in the folded state, the second mechanical part 200 and the first mechanical part 100 rotate until the second mechanical part 200 and the first mechanical part 100 are stacked, and the third mechanical part 300 and the first mechanical part 100 rotate until the third mechanical part 300 and the first mechanical part 100 are stacked. In this case, the second mechanical part 200 and the third mechanical part 300 may be located on a same side in a thickness direction of the first mechanical part 100, or the second mechanical part 200 and the third mechanical part 300 may be separately located on different sides in a thickness direction of the first mechanical part 100.

Certainly, the foldable device further has an intermediate state during switching between the unfolded state and the folded state.

An axis of the first hinge mechanism 400 and an axis of the second hinge mechanism 500 are parallel to each other. Axial directions of the first hinge mechanism 400 and the second hinge mechanism 500 may be a length direction of the foldable device, or axial directions of the first hinge mechanism 400 and the second hinge mechanism 500 may be a width direction of the foldable device.

In an example in which the axial directions of the first hinge mechanism 400 and the second hinge mechanism 500 are the length direction of the foldable device, when the foldable device is in the unfolded state, the second mechanical part 200, the first mechanical part 100, and the third mechanical part 300 are arranged side by side along the width direction of the foldable device.

In an example in which the axial directions of the first hinge mechanism 400 and the second hinge mechanism 500 are the width direction of the foldable device, when the foldable device is in the unfolded state, the second mechanical part 200, the first mechanical part 100, and the third mechanical part 300 are arranged side by side along the length direction of the foldable device.

In this embodiment of this application, the flexible display 600 is disposed on surfaces of the first mechanical part 100, the second mechanical part 200, the third mechanical part 300, the first hinge mechanism 400, and the second hinge mechanism 500. All of the first mechanical part 100, the second mechanical part 200, and the third mechanical part 300 are fastened to the flexible display 600. The first hinge mechanism 400 and the second hinge mechanism 500 may be configured to support the flexible display 600. The flexible display 600 may be configured to display information and provide an interaction interface for a user.

For example, the flexible display 600 may include but is not limited to an organic light-emitting diode (organic light-emitting diode, OLED) display, an active-matrix organic light-emitting diode (active-matrix organic light-emitting diode, AMOLED) display, a mini light-emitting diode (mini organic light-emitting diode) display, a micro light-emitting diode (micro light-emitting diode) display, a micro organic light-emitting diode (micro organic light-emitting diode) display, a quantum dot light-emitting diode (quantum dot light-emitting diode) display, or the like.

When the second mechanical part 200 rotates relative to the first mechanical part 100, the second mechanical part 200 may drive a part, fastened to the second mechanical part 200, of the flexible display 600 to rotate relative to the first mechanical part 100. When the third mechanical part 300 rotates relative to the first mechanical part 100, the third mechanical part 300 may drive a part, fastened to the third mechanical part 300, of the flexible display 600 to rotate relative to the first mechanical part 100. In this way, when the foldable device switches between the unfolded state and the folded state, the flexible display 600 is unfolded or bent under the driving by the second mechanical part 200 and the third mechanical part 300.

FIG. 2 is a diagram of another foldable device in an unfolded state according to an embodiment of this application.

As shown in FIG. 2, a first mechanical part 100 includes a first end 110 and a second end 120 that are opposite to each other, a second mechanical part 200 includes a third end 210 and a fourth end 220 that are opposite to each other, and a third mechanical part 300 includes a fifth end 310 and a sixth end 320 that are opposite to each other. The first end 110 of the first mechanical part 100 is rotatably connected to the third end 210 of the second mechanical part 200 through a first hinge mechanism 400. The second end 120 of the first mechanical part 100 is rotatably connected to the fifth end 310 of the third mechanical part 300 through a second hinge mechanism 500.

The first mechanical part 100 further includes a first side surface 130 and a second side surface 140. The first side surface 130 and the second side surface 140 are separately located on two sides in a thickness direction of the first mechanical part 100. The first side surface 130 is fastened to a flexible display 600. When the foldable device is in the unfolded state, a side surface of the second mechanical part 200 that is used for fastening the flexible display 600 and a side surface of the third mechanical part 300 that is used for fastening the flexible display 600 face a same direction as the first side surface 130.

The first mechanical part 100 may include a first middle frame and a first rear cover (not shown), and two sides of the first middle frame in a thickness direction are respectively fastened to the flexible display 600 and the first rear cover. The second mechanical part 200 may include a second middle frame and a second rear cover (not shown), and two sides of the second middle frame in a thickness direction are respectively fastened to the flexible display 600 and the second rear cover. The third mechanical part 300 may include a third middle frame and a third rear cover (not shown), and two sides of the third middle frame in a thickness direction are respectively fastened to the flexible display 600 and the third rear cover.

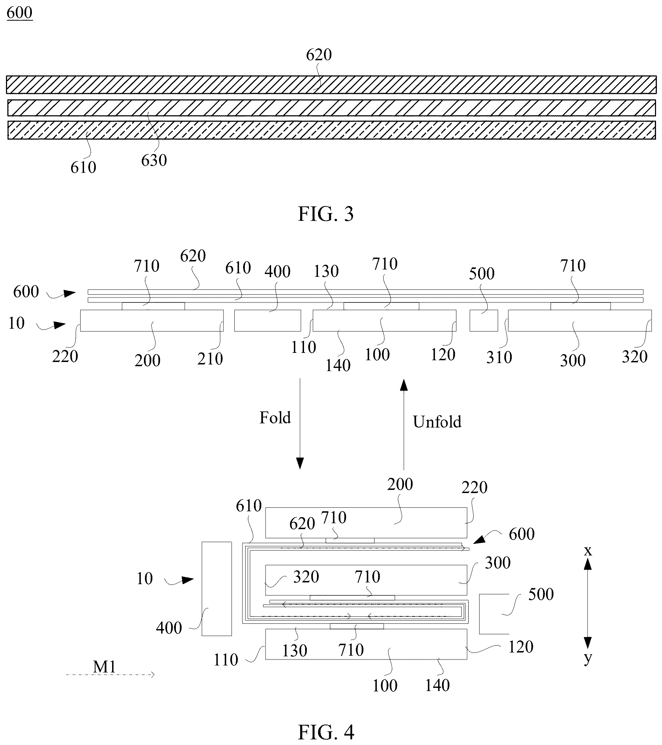

FIG. 3 is a schematic cross-sectional view of a flexible display 600 of a foldable device according to an embodiment of this application.

As shown in FIG. 3, in this embodiment of this application, the flexible display 600 includes a plurality of structural layers that are stacked, and the plurality of structural layers include a support layer 610, a display layer 630, and a cover layer 620. The support layer 610 is located on a side, facing a housing assembly 10, of the flexible display 600. The cover layer 620 is located on a side, facing away from the housing assembly 10, of the flexible display 600. The display layer 630 is located between the support layer 610 and the cover layer 620.

The support layer 610 may be a screen-integrated bamboo-inspired book-style laminate layer. The support layer 610 is configured to increase structural strength of the flexible display 600. The support layer 610 may be made of one or more of the following materials: a stainless steel sheet, a titanium alloy sheet, a copper alloy sheet, an aluminum alloy sheet, or the like.

The cover layer 620 may be configured to protect the display layer 630. The cover layer 620 is made of a transparent material, and light transmitted by the display layer 630 may be transmitted through the cover layer 620. For example, the cover layer 620 may be made of one or more of the following materials: a polyimide (polyimide, PI) film, a colorless polyimide (colorless polyimide, CPI) film, an ultra-thin flexible glass (ultra-thin glass, UTG) film, a polyethylene terephthalate (polyethylene terephthalate, PET) film, or the like.

The display layer 630 may include a plurality of pixel units, and the pixel units may transmit light in a direction toward the cover layer 620, to display an image through the cover layer 620.

It should be noted that there may alternatively be other structural layers between the display layer 630 and the cover layer 620 and between the display layer 630 and the support layer 610.

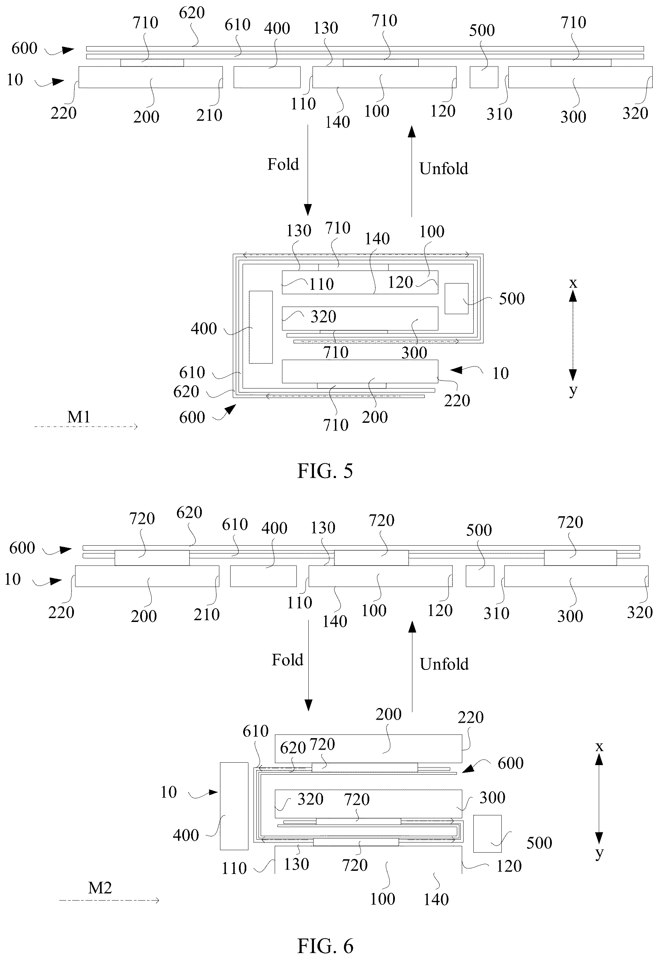

The flexible display 600 may be fastened to the housing assembly 10 through at least one of a first fastening structure 710 (as shown in FIG. 4 below) and a second fastening structure 720 (as shown in FIG. 5 below). One end of the first fastening structure 710 is fastened to the support layer 610, and the other end of the first fastening structure 710 is fastened to the housing assembly 10. One end of the second fastening structure 720 is fastened to the cover layer 620, and the other end of the second fastening structure 720 is fastened to the housing assembly 10.

For example, the first fastening structure 710 may include but is not limited to a bonding structure, a welding structure, a snap-fit structure, or the like, and the second fastening structure 720 may include but is not limited to a bonding structure, a welding structure, a snap-fit structure, or the like.

When the foldable device switches between an unfolded state and a folded state, in other words, during unfolding or bending of the flexible display 600, a structural layer, not fastened to the housing assembly 10, of the flexible display 600 undergoes displacement. Because the cover layer 620 and the support layer 610 are separately located on two sides in a thickness direction of the flexible display 600, a degree of displacement of the cover layer 620 and the support layer 610 is large.

FIG. 4 is a diagram of a foldable device according to an implementation. M1 is a displacement direction of a cover layer 620, an x direction is a first direction, and a y direction is a second direction. The first direction is a direction in which a first side surface 130 faces a flexible display 600 along a thickness direction of a first mechanical part 100. The second direction is a direction in which a second side surface 140 faces away from the flexible display 600 along the thickness direction of the first mechanical part 100.

As shown in FIG. 4, in some implementations, all of the first side surface 130, a second mechanical part 200, and a third mechanical part 300 are fastened to a support layer 610 through a first fastening structure 710, so that the first side surface 130, the second mechanical part 200, and the third mechanical part 300 are fastened to the flexible display 600. When the foldable device is in a folded state, the second mechanical part 200 and the third mechanical part 300 are located on a side in the first direction of the first mechanical part 100. In this implementation, rotation of the second mechanical part 200 toward the first side surface 130 enables a part, opposite to the first side surface 130, of the cover layer 620 to undergo displacement in a direction away from a first end 110, and rotation of the third mechanical part 300 toward the first side surface 130 enables the part, opposite to the first side surface 130, of the cover layer 620 to undergo displacement in a direction away from a second end 120. To be specific, when the foldable device switches from an unfolded state to the folded state, the displacement of the cover layer 620 that is caused by the rotation of the second mechanical part 200 and the displacement of the cover layer 620 that is caused by the rotation of the third mechanical part 300 are in opposite directions, and displacement effect is superposed on the part, opposite to the first side surface 130, of the cover layer 620. Consequently, the part, opposite to the first side surface 130, of the cover layer 620 is pressed against toward the middle of the part. This is likely to cause warping or damage to the part, opposite to the first side surface 130, of the cover layer 620.

FIG. 5 is a diagram of a foldable device according to another implementation.

As shown in FIG. 5, in some other implementations, all of a first side surface 130, a second mechanical part 200, and a third mechanical part 300 are fastened to a support layer 610 through a first fastening structure 710, so that the first side surface 130, the second mechanical part 200, and the third mechanical part 300 are fastened to a flexible display 600. When the foldable device is in a folded state, the second mechanical part 200 and the third mechanical part 300 are located on a side in a second direction of a first mechanical part 100. In this implementation, rotation of the second mechanical part 200 toward a second side surface 140 enables a part, opposite to the first side surface 130, of a cover layer 620 to undergo displacement in a direction away from a second end 120, and rotation of the third mechanical part 300 toward the second side surface 140 enables the part, opposite to the first side surface 130, of the cover layer 620 to undergo displacement in a direction away from a first end 110. To be specific, when the foldable device switches from an unfolded state to the folded state, the displacement of the cover layer 620 that is caused by the rotation of the second mechanical part 200 and the displacement of the cover layer 620 that is caused by the rotation of the third mechanical part 300 are in opposite directions, and displacement effect is superposed on the part, opposite to the first side surface 130, of the cover layer 620. Consequently, the part, opposite to the first side surface 130, of the cover layer 620 is pulled in a direction toward the second mechanical part 200 and the third mechanical part 300. This is likely to cause damage to the part, opposite to the first side surface 130, of the cover layer 620.

FIG. 6 is a diagram of a foldable device according to still another implementation. M2 is a displacement direction of a support layer 610.

As shown in FIG. 6, in still some other implementations, all of a first side surface 130, a second mechanical part 200, and a third mechanical part 300 are fastened to a cover layer 620 through a second fastening structure 720, so that the first side surface 130, the second mechanical part 200, and the third mechanical part 300 are fastened to a flexible display 600. When the foldable device is in a folded state, the second mechanical part 200 and the third mechanical part 300 are located on a side in a first direction of a first mechanical part 100. In this implementation, rotation of the second mechanical part 200 toward the first side surface 130 enables a part, opposite to the first side surface 130, of the support layer 610 to undergo displacement in a direction away from a second end 120, and rotation of the third mechanical part 300 toward the first side surface 130 enables the part, opposite to the first side surface 130, of the support layer 610 to undergo displacement in a direction away from a first end 110. To be specific, when the foldable device switches from an unfolded state to the folded state, the displacement of the support layer 610 that is caused by the rotation of the second mechanical part 200 and the displacement of the support layer 610 that is caused by the rotation of the third mechanical part 300 are in opposite directions, and displacement effect is superposed on the part, opposite to the first side surface 130, of the support layer 610. Consequently, the part, opposite to the first side surface 130, of the support layer 610 is pulled in a direction toward the second mechanical part 200 and the third mechanical part 300. This is likely to cause damage to the part, opposite to the first side surface 130, of the support layer 610.

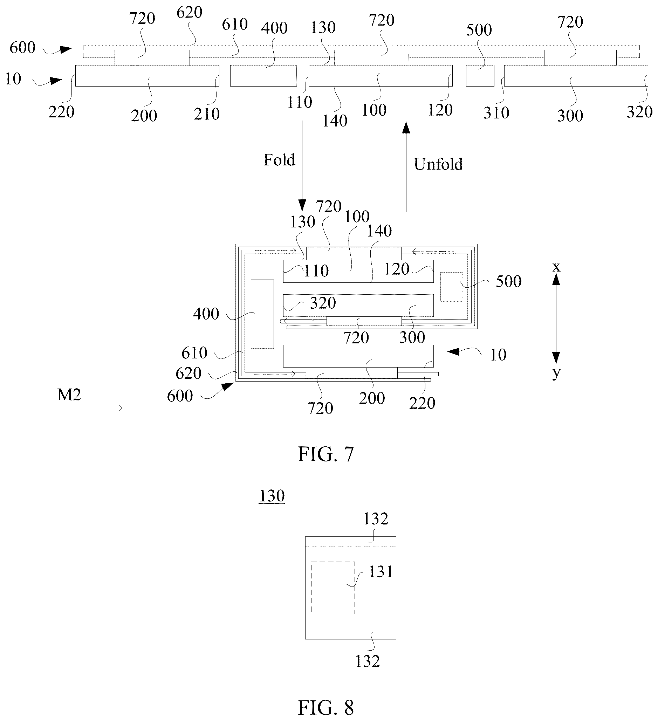

FIG. 7 is a diagram of a foldable device according to still another implementation.

As shown in FIG. 7, in still some other implementations, all of a first side surface 130, a second mechanical part 200, and a third mechanical part 300 are fastened to a cover layer 620 through a second fastening structure 720, so that the first side surface 130, the second mechanical part 200, and the third mechanical part 300 are fastened to a flexible display 600. When the foldable device is in a folded state, the second mechanical part 200 and the third mechanical part 300 are located on a side in a second direction of a first mechanical part 100. In this implementation, rotation of the second mechanical part 200 toward a second side surface 140 enables a part, opposite to the first side surface 130, of the support layer 610 to undergo displacement in a direction away from a first end 110, and rotation of the third mechanical part 300 toward the second side surface 140 enables the part, opposite to the first side surface 130, of the support layer 610 to undergo displacement in a direction away from a second end 120. To be specific, when the foldable device switches from an unfolded state to the folded state, the displacement of the support layer 610 that is caused by the rotation of the second mechanical part 200 and the displacement of the support layer 610 that is caused by the rotation of the third mechanical part 300 are in opposite directions, and displacement effect is superposed on the part, opposite to the first side surface 130, of the support layer 610. Consequently, the part, opposite to the first side surface 130, of the support layer 610 is pressed against toward the middle of the part. This is likely to cause warping or damage to the part, opposite to the first side surface 130, of the support layer 610.

To sum up, in the foregoing four implementations, when the foldable device switches from the unfolded state to the folded state, a risk of damage to the flexible display 600 is high.

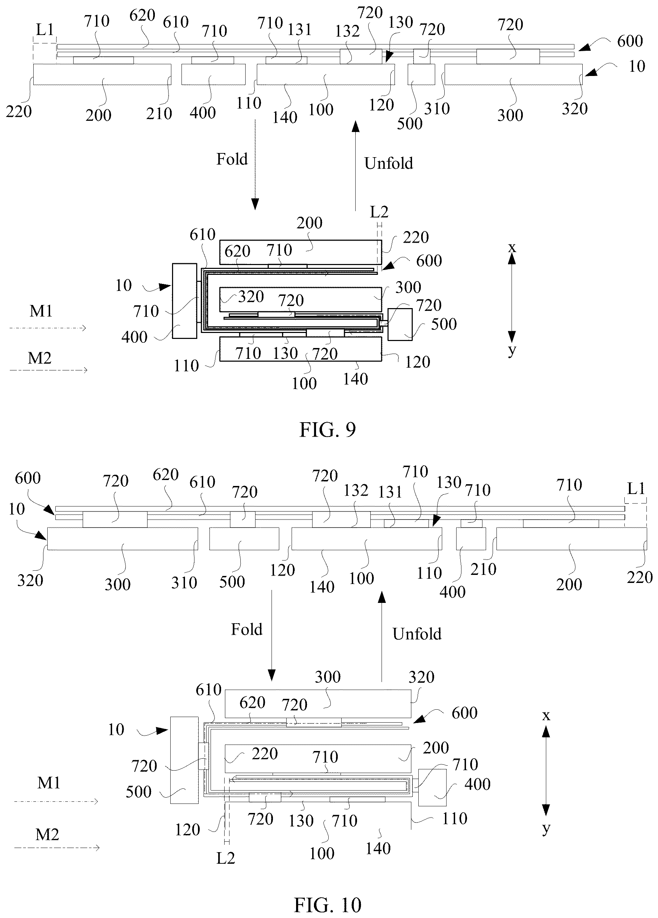

FIG. 8 is a diagram of a foldable device according to an embodiment of this application. FIG. 9 is a diagram of a first side surface 130 of a foldable device according to an embodiment of this application.

As shown in FIG. 8 and FIG. 9, based on this, in some embodiments of this application, the first side surface 130 of the foldable device includes a first region 131 and a second region 132, a second mechanical part 200 and the first region 131 are fastened to a support layer 610 through a first fastening structure 710, and a third mechanical part 300 and the second region 132 are fastened to a cover layer 620 through a second fastening structure 720.

In this way, when the foldable device switches from an unfolded state to a folded state, a part of the support layer 610 that is opposite to the second mechanical part 200 and a part of the support layer 610 that is opposite to a region between the second mechanical part 200 and the first region 131 do not undergo displacement relative to a housing assembly 10, and a part of the support layer 610 that is opposite to the third mechanical part 300 and a part of the support layer 610 that is opposite to a region between the third mechanical part 300 and the first region 131 undergo overall displacement toward a same direction. This prevents two parts of the support layer 610 from undergoing displacement toward opposite directions due to rotation of the second mechanical part 200 and the third mechanical part 300 relative to a first mechanical part 100, and avoids damage to the support layer 610 that is caused by a case in which the support layer 610 is pressed against or pulled due to superposition of two parts of displacement toward opposite directions. When the foldable device switches from the unfolded state to the folded state, a part of the cover layer 620 that is opposite to the third mechanical part 300 and a part of the cover layer 620 that is opposite to a region between the third mechanical part 300 and the second region 132 do not undergo displacement relative to the housing assembly 10, and a part of the cover layer 620 that is opposite to the second mechanical part 200 and a part of the cover layer 620 that is opposite to a region between the second mechanical part 200 and the second region 132 undergo overall displacement toward a same direction. This prevents two parts of the cover layer 620 from undergoing displacement toward opposite directions due to rotation of the second mechanical part 200 and the third mechanical part 300 relative to the first mechanical part 100, and avoids damage to the cover layer 620 that is caused by a case in which the cover layer 620 is pressed against or pulled due to superposition of two parts of displacement toward opposite directions. In this way, a risk of damage to a flexible display 600 can be reduced. In addition, based on a low risk of damage to the flexible display 600, a limitation on a folding form and a folding mode of a foldable device of a tri-fold structure or a structure with more folds is small.

For example, the second region 132 may be located at edges on two sides of the first side surface 130 in an axial direction of a first hinge mechanism 400. At least a part of the first region 131 may be located between second regions 132 at the edges on the two sides of the first side surface 130.

In this way, a fastening region between the first side surface 130 and the support layer 610 and a fastening region between the first side surface 130 and the cover layer 620 can be large, so that the first side surface 130 is stably fastened to the flexible display 600.

For example, the first region 131 and the second region 132 may alternatively be arranged along an extension direction of the first end 110 and the second end 120. The first region 131 is close to the first end 110, and the second region 132 is close to the second end 120.

In some examples in which the second mechanical part 200 and the first region 131 are fastened to the support layer 610 through the first fastening structure 710, and the third mechanical part 300 and the second region 132 are fastened to the cover layer 620 through the second fastening structure 720, the first hinge mechanism 400 is fastened to the support layer 610 through the first fastening structure 710.

In this way, when the foldable device switches between the folded state and the unfolded state, deformation of a part, opposite to the first hinge mechanism 400, of the flexible display 600 can be controlled. In addition, after the first hinge mechanism 400 is fastened to the support layer 610 through the first fastening structure 710, displacement of the support layer 610 and the cover layer 620 is not affected.

In some examples in which the second mechanical part 200 and the first region 131 are fastened to the support layer 610 through the first fastening structure 710, and the third mechanical part 300 and the second region 132 are fastened to the cover layer 620 through the second fastening structure 720, a second hinge mechanism 500 is fastened to the cover layer 620 through the second fastening structure 720.

In this way, when the foldable device switches between the folded state and the unfolded state, deformation of a part, opposite to the second hinge mechanism 500, of the flexible display 600 can be controlled. In addition, after the second hinge mechanism 500 is fastened to the cover layer 620 through the second fastening structure 720, displacement of the support layer 610 and the cover layer 620 is not affected.

In some examples in which the second mechanical part 200 and the first region 131 are fastened to the support layer 610 through the first fastening structure 710, and the third mechanical part 300 and the second region 132 are fastened to the cover layer 620 through the second fastening structure 720, when the foldable device is in the folded state, the second mechanical part 200 and the third mechanical part 300 are located on a same side in a thickness direction of the first mechanical part 100.

In this way, the second mechanical part 200 and the third mechanical part 300 can be folded toward a same side of the first mechanical part 100 on a basis that the support layer 610 and the cover layer 620 are not likely to be pressed against or pulled due to displacement and cause damage to the flexible display 600. In addition, when the foldable device switches between the folded state and the unfolded state, a user only needs to perform an operation on a same side of the first mechanical part 100, making it convenient for the user to perform an operation.

In some examples in which the second mechanical part 200 and the first region 131 are fastened to the support layer 610 through the first fastening structure 710, and the third mechanical part 300 and the second region 132 are fastened to the cover layer 620 through the second fastening structure 720, when the foldable device is in the folded state, the second mechanical part 200 and the third mechanical part 300 are located on a side in a first direction of the first mechanical part 100.

In this way, when the foldable device is in the folded state, the flexible display 600 is blocked by the first mechanical part 100, the second mechanical part 200, the third mechanical part 300, the first hinge mechanism 400, and the second hinge mechanism 500, and the first mechanical part 100, the second mechanical part 200, the third mechanical part 300, the first hinge mechanism 400, and the second hinge mechanism 500 can protect the flexible display 600. In addition, when the foldable device switches from the unfolded state to the folded state, the part of the support layer 610 that is opposite to the third mechanical part 300 and the part of the support layer 610 that is opposite to the region between the third mechanical part 300 and the first region 131 undergo overall displacement toward a direction away from a sixth end 320, and the part of the cover layer 620 that is opposite to the second mechanical part 200 and the part of the cover layer 620 that is opposite to the region between the second mechanical part 200 and the second region 132 undergo overall displacement toward a direction away from the second end 120. In this way, when the foldable device is in the unfolded state, one end of the support layer 610 and one end of the cover layer 620 may be attached to the sixth end 320.

In some examples in which the second mechanical part 200 and the first region 131 are fastened to the support layer 610 through the first fastening structure 710, and the third mechanical part 300 and the second region 132 are fastened to the cover layer 620 through the second fastening structure 720, when the foldable device is in the folded state, the second mechanical part 200 is located on the side in the first direction of the first mechanical part 100. One end of the flexible display 600 is located between a third end 210 and a fourth end 220. When the foldable device is in the unfolded state, a first spacing L1 exists between the cover layer 620 and the fourth end 220. When the foldable device is in the folded state, a second spacing L2 exists between the cover layer 620 and the fourth end 220. The first spacing L1 is greater than the second spacing L2. To be specific, the first spacing L1 is used for an end, close to the fourth end 220, of the cover layer 620 to move toward the fourth end 220 when the foldable device switches to the folded state.

In this way, when the foldable device switches from the unfolded state to the folded state, the second mechanical part 200 is not likely to be pressed against due to displacement of the cover layer 620 and cause damage to the flexible display 600.

In some examples in which the second mechanical part 200 and the first region 131 are fastened to the support layer 610 through the first fastening structure 710, and the third mechanical part 300 and the second region 132 are fastened to the cover layer 620 through the second fastening structure 720, when the foldable device is in the folded state, the second mechanical part 200 and the third mechanical part 300 are located on a same side in the thickness direction of the first mechanical part 100, both the second mechanical part 200 and the third mechanical part 300 are stacked on a surface of the first mechanical part 100, and the second mechanical part 200 and the third mechanical part 300 are located at a same layer.

In this way, the foldable device can have a small thickness after being folded.

As shown in FIG. 9, in some examples in which the second mechanical part 200 and the first region 131 are fastened to the support layer 610 through the first fastening structure 710, and the third mechanical part 300 and the second region 132 are fastened to the cover layer 620 through the second fastening structure 720, when the foldable device is in the folded state, the second mechanical part 200 and the third mechanical part 300 are located on a same side in the thickness direction of the first mechanical part 100, and one of the second mechanical part 200 and the third mechanical part 300 is located between the first mechanical part 100 and the other one of the second mechanical part 200 and the third mechanical part 300.

In this way, the foldable device can have a small size in a length direction or a width direction after being folded.

As shown in FIG. 9, in some examples in which the second mechanical part 200 and the first region 131 are fastened to the support layer 610 through the first fastening structure 710, and the third mechanical part 300 and the second region 132 are fastened to the cover layer 620 through the second fastening structure 720, when the foldable device is in the folded state, the third mechanical part 300 is located between the first side surface 130 and the second mechanical part 200.

FIG. 10 is a diagram of another foldable device according to an embodiment of this application.

As shown in FIG. 10, in some examples in which a second mechanical part 200 and a first region 131 are fastened to a support layer 610 through a first fastening structure 710, and a third mechanical part 300 and a second region 132 are fastened to a cover layer 620 through a second fastening structure 720, when the foldable device is in a folded state, the second mechanical part 200 is located between a first side surface 130 and the third mechanical part 300.

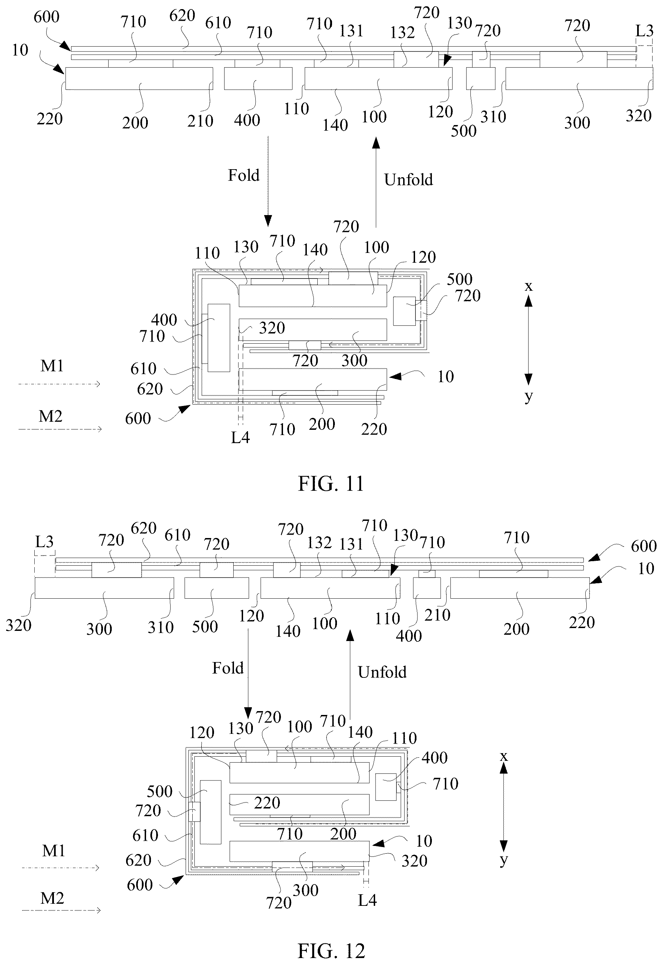

FIG. 11 is a diagram of still another foldable device according to an embodiment of this application.

As shown in FIG. 11, in some examples in which a second mechanical part 200 and a first region 131 are fastened to a support layer 610 through a first fastening structure 710, and a third mechanical part 300 and a second region 132 are fastened to a cover layer 620 through a second fastening structure 720, when the foldable device is in a folded state, the second mechanical part 200 and the third mechanical part 300 are located on a side in a second direction of a first mechanical part 100.

In this way, when the foldable device is in the folded state, a part of a flexible display 600 is exposed, and a display function may be implemented by using the exposed part of the flexible display 600. In addition, when the foldable device switches from an unfolded state to the folded state, a part of the support layer 610 that is opposite to the third mechanical part 300 and a part of the support layer 610 that is opposite to a region between the third mechanical part 300 and the first region 131 undergo overall displacement toward a direction away from a first end 110, and a part of the cover layer 620 that is opposite to the second mechanical part 200 and a part of the cover layer 620 that is opposite to a region between the second mechanical part 200 and the second region 132 undergo overall displacement toward a direction away from a fourth end 220. In this way, when the foldable device is in the unfolded state, one end of the support layer 610 and one end of the cover layer 620 may be attached to the fourth end 220.

In some examples in which the second mechanical part 200 and the first region 131 are fastened to the support layer 610 through the first fastening structure 710, and the third mechanical part 300 and the second region 132 are fastened to the cover layer 620 through the second fastening structure 720, when the foldable device is in the folded state, the third mechanical part 300 is located on the side in the second direction of the first mechanical part 100. One end of the flexible display 600 is located between a fifth end 310 and a sixth end 320. When the foldable device is in the unfolded state, a third spacing L3 exists between the support layer 610 and the sixth end 320. When the foldable device is in the folded state, a fourth spacing L4 exists between the support layer 610 and the sixth end 320. The third spacing L3 is greater than the fourth spacing L4. To be specific, the third spacing L3 is used for an end, close to the sixth end 320, of the support layer 610 to move toward the sixth end 320 when the foldable device switches to the folded state.

In this way, when the foldable device switches from the unfolded state to the folded state, the third mechanical part 300 is not likely to be pressed against due to displacement of the support layer 610 and cause damage to the flexible display 600.

As shown in FIG. 11, in some examples in which the second mechanical part 200 and the first region 131 are fastened to the support layer 610 through the first fastening structure 710, and the third mechanical part 300 and the second region 132 are fastened to the cover layer 620 through the second fastening structure 720, when the foldable device is in the folded state, the third mechanical part 300 is located between a second side surface 140 and the second mechanical part 200.

FIG. 12 is a diagram of still another foldable device according to an embodiment of this application.

As shown in FIG. 12, in some examples in which a second mechanical part 200 and a first region 131 are fastened to a support layer 610 through a first fastening structure 710, and a third mechanical part 300 and a second region 132 are fastened to a cover layer 620 through a second fastening structure 720, when the foldable device is in a folded state, the second mechanical part 200 is located between a second side surface 140 and the third mechanical part 300.

In this way, when the foldable device switches from an unfolded state to the folded state, a spacing between an exposed part of the cover layer 620 and a sixth end 320 does not increase due to displacement, and displacement of the cover layer 620 is not likely to be found by a user, and has slight impact on using, by the user, an exposed part of a flexible display 600.

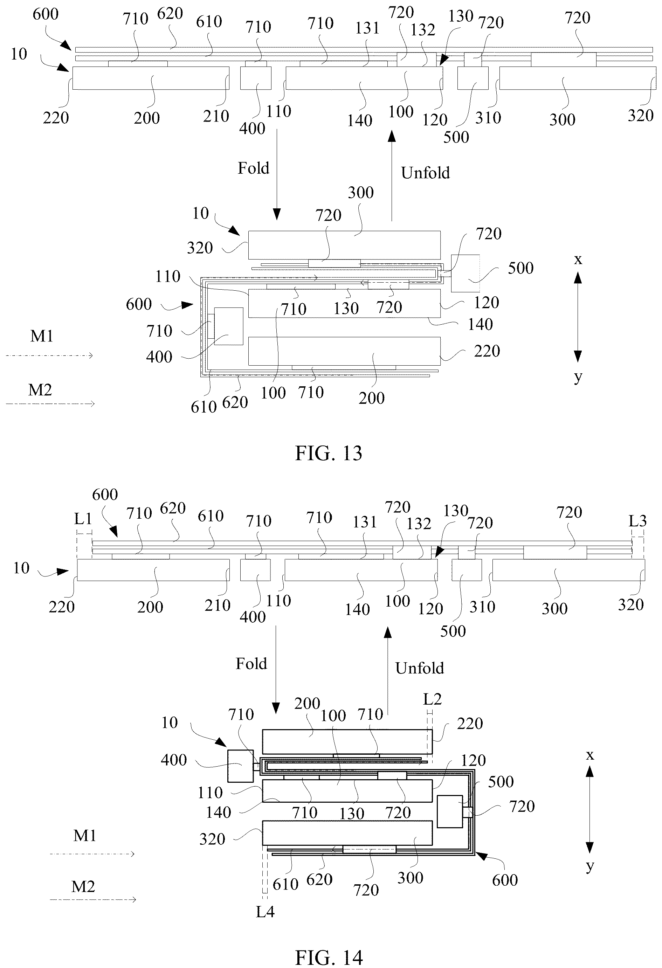

FIG. 13 is a diagram of still another foldable device according to an embodiment of this application.

As shown in FIG. 13, in some examples in which a second mechanical part 200 and a first region 131 are fastened to a support layer 610 through a first fastening structure 710, and a third mechanical part 300 and a second region 132 are fastened to a cover layer 620 through a second fastening structure 720, when the foldable device is in a folded state, the second mechanical part 200 is located on a side in a second direction of a first mechanical part 100, and the third mechanical part 300 is located on a side in a first direction of the first mechanical part 100. In this case, when the foldable device switches from an unfolded state to the folded state, a part of the support layer 610 that is opposite to the third mechanical part 300 and a part of the support layer 610 that is opposite to a region between the third mechanical part 300 and the first region 131 undergo overall displacement toward a direction away from a sixth end 320, and a part of the cover layer 620 that is opposite to the second mechanical part 200 and a part of the cover layer 620 that is opposite to a region between the second mechanical part 200 and the second region 132 undergo overall displacement toward a direction away from a fourth end 220. In this way, when the foldable device is in the unfolded state, one end of the support layer 610 and one end of the cover layer 620 may be attached to the fourth end 220, and the other end of the support layer 610 and the other end of the cover layer 620 may be attached to the sixth end 320.

FIG. 14 is a diagram of still another foldable device according to an embodiment of this application.

As shown in FIG. 14, in some examples in which a second mechanical part 200 and a first region 131 are fastened to a support layer 610 through a first fastening structure 710, and a third mechanical part 300 and a second region 132 are fastened to a cover layer 620 through a second fastening structure 720, when the foldable device is in a folded state, the second mechanical part 200 is located on a side in a first direction of a first mechanical part 100, and the third mechanical part 300 is located on a side in a second direction of the first mechanical part 100. In this case, when the foldable device switches from an unfolded state to the folded state, a part of the support layer 610 that is opposite to the third mechanical part 300 and a part of the support layer 610 that is opposite to a region between the third mechanical part 300 and the first region 131 undergo overall displacement toward a direction away from a first end 110, and a part of the cover layer 620 that is opposite to the second mechanical part 200 and a part of the cover layer 620 that is opposite to a region between the second mechanical part 200 and the second region 132 undergo overall displacement toward a direction away from a second end 120. When the foldable device is in the unfolded state, a first spacing L1 exists between the cover layer 620 and a fourth end 220, and a third spacing L3 exists between the support layer 610 and a sixth end 320. When the foldable device is in the folded state, a second spacing L2 exists between the cover layer 620 and the fourth end 220, and a fourth spacing L4 exists between the support layer 610 and the sixth end 320. The first spacing L1 is greater than the second spacing L2, and the third spacing L3 is greater than the fourth spacing L4.

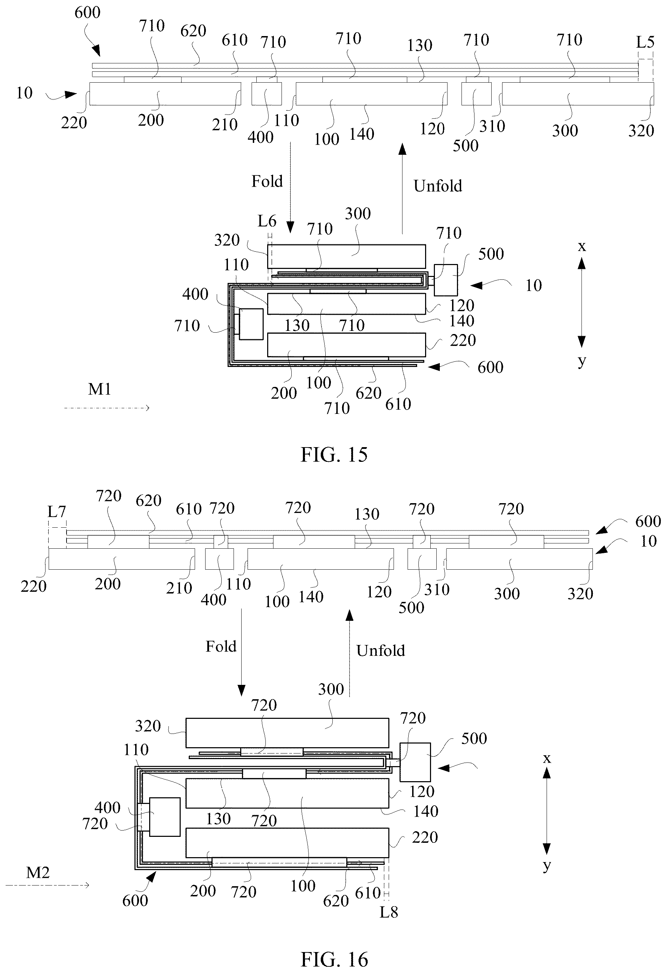

FIG. 15 is a diagram of still another foldable device according to an embodiment of this application.

As shown in FIG. 15, in some other embodiments of this application, one of a support layer 610 and a cover layer 620 is fastened to a first side surface 130, a second mechanical part 200, and a third mechanical part 300. When the foldable device is in a folded state, the second mechanical part 200 is located on a side in a second direction of a first mechanical part 100, and the third mechanical part 300 is located on a side in a first direction of the first mechanical part 100.

In this way, the one of the support layer 610 and the cover layer 620 that is fastened to the first side surface 130, the second mechanical part 200, and the third mechanical part 300 does not undergo displacement relative to a housing assembly 10, and the one of the support layer 610 and the cover layer 620 that is fastened to the first side surface 130, the second mechanical part 200, and the third mechanical part 300 does not have the following problem: Two parts of the layer undergo displacement toward opposite directions, and consequently, the layer is pressed against or pulled. Therefore, the layer is not likely to be damaged due to superposition of two parts of displacement toward opposite directions. Rotation of the second mechanical part 200 and the third mechanical part 300 relative to the first mechanical part 100 enables one of the support layer 610 and the cover layer 620 that is not fastened to the first side surface 130, the second mechanical part 200, and the third mechanical part 300 to undergo displacement toward a same direction. To be specific, for the one of the support layer 610 and the cover layer 620 that is not fastened to the first side surface 130, the second mechanical part 200, and the third mechanical part 300, displacement caused by rotation of the second mechanical part 200 relative to the first mechanical part 100 may supplement displacement caused by rotation of the third mechanical part 300 relative to the first mechanical part 100. In this way, the one of the support layer 610 and the cover layer 620 that is not fastened to the first side surface 130, the second mechanical part 200, and the third mechanical part 300 undergoes overall displacement toward one direction, and the one of the support layer 610 and the cover layer 620 that is not fastened to the first side surface 130, the second mechanical part 200, and the third mechanical part 300 does not have the following problem: Two parts of the layer undergo displacement toward opposite directions, and consequently, the layer is pressed against or pulled. Therefore, the layer is not likely to be damaged due to superposition of two parts of displacement toward opposite directions. In this way, a risk of damage to a flexible display 600 can be reduced.

In some examples in which one of the support layer 610 and the cover layer 620 is fastened to the first side surface 130, the second mechanical part 200, and the third mechanical part 300, and when the foldable device is in the folded state, the second mechanical part 200 is located on the side in the second direction of the first mechanical part 100, and the third mechanical part 300 is located on the side in the first direction of the first mechanical part 100, the first side surface 130, the second mechanical part 200, and the third mechanical part 300 are fastened to the support layer 610 through a first fastening structure 710.

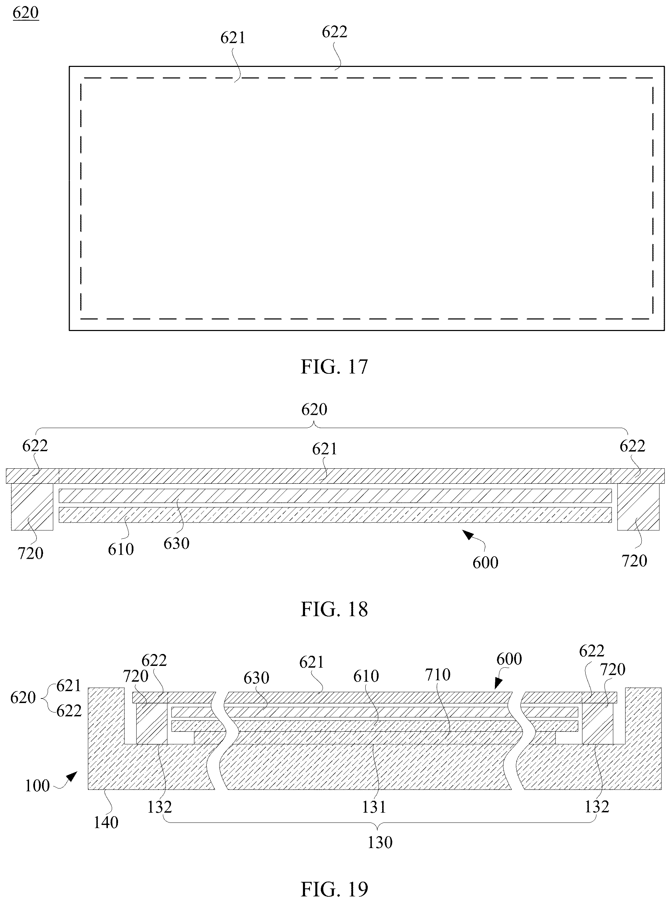

In this way, a fastening position between the flexible display 600 and the housing assembly 10 does not affect an arrangement of a display layer 630 of the flexible display 600, and has slight impact on setting and display effect of a display region 621 (as shown in FIG. 17 below) of the flexible display 600. This facilitates a narrow-bezel design of the foldable device. In addition, when the foldable device switches from an unfolded state to the folded state, the cover layer 620 undergoes overall displacement in a direction away from a fourth end 220. In this way, when the foldable device is in the unfolded state, one end of the support layer 610 and one end of the cover layer 620 may be attached to the fourth end 220.

In some examples in which the first side surface 130, the second mechanical part 200, and the third mechanical part 300 are fastened to the support layer 610 through the first fastening structure 710, and when the foldable device is in the folded state, the second mechanical part 200 is located on the side in the second direction of the first mechanical part 100, and the third mechanical part 300 is located on the side in the first direction of the first mechanical part 100, a first hinge mechanism 400 is fastened to the support layer 610 through the first fastening structure 710.

In this way, when the foldable device switches between the folded state and the unfolded state, deformation of a part, opposite to the first hinge mechanism 400, of the flexible display 600 can be controlled. In addition, after the first hinge mechanism 400 is fastened to the support layer 610 through the first fastening structure 710, displacement of the support layer 610 and the cover layer 620 is not affected. In addition, the first hinge mechanism 400 being fastened to the support layer 610 through the first fastening structure 710 does not affect an arrangement of the display layer 630 of the flexible display 600, and has slight impact on setting and display effect of the display region 621 of the flexible display 600. This facilitates a narrow-bezel design of the foldable device.

In some examples in which the first side surface 130, the second mechanical part 200, and the third mechanical part 300 are fastened to the support layer 610 through the first fastening structure 710, and when the foldable device is in the folded state, the second mechanical part 200 is located on the side in the second direction of the first mechanical part 100, and the third mechanical part 300 is located on the side in the first direction of the first mechanical part 100, a second hinge mechanism 500 is fastened to the support layer 610 through the first fastening structure 710.

In this way, when the foldable device switches between the folded state and the unfolded state, deformation of a part, opposite to the second hinge mechanism 500, of the flexible display 600 can be controlled. In addition, after the second hinge mechanism 500 is fastened to the support layer 610 through the first fastening structure 710, displacement of the support layer 610 and the cover layer 620 is not affected. In addition, the second hinge mechanism 500 being fastened to the support layer 610 through the first fastening structure 710 does not affect an arrangement of the display layer 630 of the flexible display 600, and has slight impact on setting and display effect of the display region 621 of the flexible display 600. This facilitates a narrow-bezel design of the foldable device.

In some examples in which the first side surface 130, the second mechanical part 200, and the third mechanical part 300 are fastened to the support layer 610 through the first fastening structure 710, and when the foldable device is in the folded state, the second mechanical part 200 is located on the side in the second direction of the first mechanical part 100, and the third mechanical part 300 is located on the side in the first direction of the first mechanical part 100, one end of the flexible display 600 is located between a fifth end 310 and a sixth end 320. When the foldable device is in the unfolded state, a fifth spacing L5 exists between the cover layer 620 and the sixth end 320. When the foldable device is in the folded state, a sixth spacing L6 exists between the cover layer 620 and the sixth end 320. The fifth spacing L5 is greater than the sixth spacing L6. To be specific, the fifth spacing L5 is used for an end, close to the sixth end 320, of the cover layer 620 to move toward the sixth end 320 when the foldable device switches to the folded state.

In this way, when the foldable device switches from the unfolded state to the folded state, the third mechanical part 300 is not likely to be pressed against due to displacement of the cover layer 620 and cause damage to the flexible display 600.

FIG. 16 is a diagram of still another foldable device according to an embodiment of this application.

As shown in FIG. 16, in some examples in which one of a support layer 610 and a cover layer 620 is fastened to a first side surface 130, a second mechanical part 200, and a third mechanical part 300, and when the foldable device is in a folded state, the second mechanical part 200 is located on a side in a second direction of a first mechanical part 100, and the third mechanical part 300 is located on a side in a first direction of the first mechanical part 100, the first side surface 130, the second mechanical part 200, and the third mechanical part 300 are fastened to the cover layer 620 through a second fastening structure 720.

In this way, when the foldable device switches from an unfolded state to the folded state, the cover layer 620 does not undergo displacement, and slight impact is imposed on using, by a user, an exposed part of a flexible display 600 when the foldable device is in the folded state. In addition, when the foldable device switches from the unfolded state to the folded state, the support layer 610 undergoes overall displacement in a direction away from a sixth end 320. In this way, when the foldable device is in the unfolded state, one end of the support layer 610 and one end of the cover layer 620 may be attached to the sixth end 320.

In some examples in which the first side surface 130, the second mechanical part 200, and the third mechanical part 300 are fastened to the cover layer 620 through the second fastening structure 720, and when the foldable device is in the folded state, the second mechanical part 200 is located on the side in the second direction of the first mechanical part 100, and the third mechanical part 300 is located on the side in the first direction of the first mechanical part 100, a first hinge mechanism 400 is fastened to the cover layer 620 through the second fastening structure 720.

In this way, when the foldable device switches between the folded state and the unfolded state, deformation of a part, opposite to the first hinge mechanism 400, of the flexible display 600 can be controlled. In addition, after the first hinge mechanism 400 is fastened to the cover layer 620 through the second fastening structure 720, displacement of the support layer 610 and the cover layer 620 is not affected.

In some examples in which the first side surface 130, the second mechanical part 200, and the third mechanical part 300 are fastened to the cover layer 620 through the second fastening structure 720, and when the foldable device is in the folded state, the second mechanical part 200 is located on the side in the second direction of the first mechanical part 100, and the third mechanical part 300 is located on the side in the first direction of the first mechanical part 100, a second hinge mechanism 500 is fastened to the cover layer 620 through the second fastening structure 720.

In this way, when the foldable device switches between the folded state and the unfolded state, deformation of a part, opposite to the second hinge mechanism 500, of the flexible display 600 can be controlled. In addition, after the second hinge mechanism 500 is fastened to the cover layer 620 through the second fastening structure 720, displacement of the support layer 610 and the cover layer 620 is not affected.

In some examples in which the first side surface 130, the second mechanical part 200, and the third mechanical part 300 are fastened to the cover layer 620 through the second fastening structure 720, and when the foldable device is in the folded state, the second mechanical part 200 is located on the side in the second direction of the first mechanical part 100, and the third mechanical part 300 is located on the side in the first direction of the first mechanical part 100, one end of the flexible display 600 is located between a third end 210 and a fourth end 220. When the foldable device is in the unfolded state, a seventh spacing L7 exists between the support layer 610 and the fourth end 220. When the foldable device is in the folded state, an eighth spacing L8 exists between the support layer 610 and the fourth end 220. The seventh spacing L7 is greater than the eighth spacing L8. To be specific, the seventh spacing L7 is used for an end, close to the fourth end 220, of the support layer 610 to move toward the fourth end 220 when the foldable device switches to the folded state.

In this way, when the foldable device switches from the unfolded state to the folded state, the second mechanical part 200 is not likely to be pressed against due to displacement of the support layer 610 and cause damage to the flexible display 600.

FIG. 17 is a diagram of a cover layer 620 of a foldable device according to an embodiment of this application. FIG. 18 is a diagram of a joint between a flexible display 600 of a foldable device and a second fastening structure 720 according to an embodiment of this application.

As shown in FIG. 17 and FIG. 18, in some examples in which the second fastening structure 720 exists, the cover layer 620 includes a display region 621 and a fastening region 622. An orthographic projection of the display region 621 along a thickness direction of the flexible display 600 coincides with an orthographic projection of a display layer 630 along the thickness direction of the flexible display 600. The fastening region 622 protrudes from an outer edge of the display layer 630, and the second fastening structure 720 is located in the fastening region 622. That is, the second fastening structure 720 is located at an edge, protruding from the display layer 630, of the cover layer 620. The second fastening structure 720 enables the edge, protruding from the display layer 630, of the cover layer 620 to be fastened to a housing assembly 10.

In this way, the second fastening structure 720 has slight impact on display effect of the flexible display 600.

FIG. 19 is a schematic cross-sectional view of a plane A-A in FIG. 1.

As shown in FIG. 19, in an example in which a first side surface 130 includes a first region 131 and a second region 132, the first region 131 is fastened to a support layer 610 through a first fastening structure 710, and the second region 132 is fastened to a cover layer 620 through a second fastening structure 720, a display region 621 is connected to fastening regions 622 on two sides in an axial direction of the first hinge mechanism 400, the first side surface 130 has second regions 132, opposite to the fastening regions 622, at edges on the two sides in the axial direction of the first hinge mechanism 400, and the fastening regions 622 located on the two sides of the display region 621 in the axial direction of the first hinge mechanism 400 are fastened, through second fastening structures 720, to the second regions 132 of the first side surface 130 that are located at the edges on the two sides in the axial direction of the first hinge mechanism 400. That is, edges of the cover layer 620 on the two sides in the axial direction of the first hinge mechanism 400 protrude from a display layer 630, and are fastened to edges of the first side surface 130 on the two sides in the axial direction of the first hinge mechanism 400 through the second fastening structures 720. In the axial direction of the first hinge mechanism 400, the first region 131 may be located between the second regions 132 of the first side surface 130 at the edges on the two sides. To be specific, the first fastening structure 710 connected to the first region 131 may be located between the second fastening structures 720 disposed at the edges of the first side surface 130 on the two sides in the axial direction of the first hinge mechanism 400.

In some examples in which the first hinge mechanism 400 is fastened to the cover layer 620 through the second fastening structures 720, the edges of the cover layer 620 on the two sides in the axial direction of the first hinge mechanism 400 protrude from the display layer 630, and are fastened to the first hinge mechanism 400 through the second fastening structures 720.

In some examples in which the second hinge mechanism 500 is fastened to the cover layer 620 through the second fastening structures 720, edges of the cover layer 620 on two sides in an axial direction of the second hinge mechanism 500 protrude from the display layer 630, and are fastened to the second hinge mechanism 500 through the second fastening structures 720.

In some examples in which the second mechanical part 200 is fastened to the cover layer 620 through the second fastening structures 720, the edges of the cover layer 620 on the two sides in the axial direction of the first hinge mechanism 400 may protrude from the display layer 630, and are fastened to the second mechanical part 200 through the second fastening structures 720. When one end of the flexible display 600 is located between a third end 210 and a fourth end 220, an edge, on a side close to the fourth end 220, of the cover layer 620 may further protrude from the display layer 630, and is fastened to the second mechanical part 200 through the second fastening structure 720.

In some examples in which the third mechanical part 300 is fastened to the cover layer 620 through the second fastening structures 720, the edges of the cover layer 620 on the two sides in the axial direction of the second hinge mechanism 500 may protrude from the display layer 630, and are fastened to the third mechanical part 300 through the second fastening structures 720. When one end of the flexible display 600 is located between a fifth end 310 and a sixth end 320, an edge, on a side close to the sixth end 320, of the cover layer 620 may further protrude from the display layer 630, and is fastened to the third mechanical part 300 through the second fastening structure 720.

In some examples in which the first fastening structure 710 exists, the first fastening structure 710 may be a bonding structure. To be specific, one end of the first fastening structure 710 is bonded and fastened to the support layer 610, and the other end of the first fastening structure 710 is bonded and fastened to the housing assembly 10. For example, the first fastening structure 710 may be back adhesive.

In this way, it is convenient to fasten the support layer 610 to the housing assembly 10 through the first fastening structure 710.

In some examples in which the second fastening structure 720 exists, the second fastening structure 720 may be a bonding structure. To be specific, one end of the second fastening structure 720 is bonded and fastened to the cover layer 620, and the other end of the second fastening structure 720 is bonded and fastened to the housing assembly 10. For example, the second fastening structure 720 may be frame adhesive.

In this way, it is convenient to fasten the cover layer 620 to the housing assembly 10 through the second fastening structure 720.

In some examples in which the second mechanical part 200 and the first region 131 are fastened to the support layer 610 through the first fastening structure 710, and the third mechanical part 300 and the second region 132 are fastened to the cover layer 620 through the second fastening structure 720, the second mechanical part 200 and the first region 131 are bonded and fastened to the support layer 610 through the first fastening structure 710, the third mechanical part 300 and the second region 132 are bonded and fastened to the cover layer 620 through the second fastening structure 720, the first hinge mechanism 400 may be bonded and fastened to the support layer 610 through the first fastening structure 710, and the second hinge mechanism 500 may be bonded and fastened to the cover layer 620 through the second fastening structure 720.

In some examples in which all of the first side surface 130, the second mechanical part 200, and the third mechanical part 300 are fastened to the support layer 610 through the first fastening structure 710, all of the first side surface 130, the second mechanical part 200, and the third mechanical part 300 are bonded and fastened to the support layer 610 through the first fastening structure 710, and both the first hinge mechanism 400 and the second hinge mechanism 500 may be bonded and fastened to the support layer 610 through the first fastening structure 710.

In some examples in which all of the first side surface 130, the second mechanical part 200, and the third mechanical part 300 are fastened to the cover layer 620 through the second fastening structure 720, all of the first side surface 130, the second mechanical part 200, and the third mechanical part 300 are bonded and fastened to the cover layer 620 through the second fastening structure 720, and both the first hinge mechanism 400 and the second hinge mechanism 500 may be bonded and fastened to the cover layer 620 through the second fastening structure 720.

In descriptions of embodiments of this application, it should be noted that, unless otherwise clearly specified and limited, the terms "mount", "connect", and "connection" should be understood in a broad sense. For example, the connection may be fastening, or may be an indirect connection through an intermediate medium, or may be an internal connection between two components or an interaction relationship between two components. Persons of ordinary skill in the art may understand specific meanings of the foregoing terms in embodiments of this application based on specific cases.

In the specification, claims, and accompanying drawings of embodiments of this application, the terms "first", "second", "third", "fourth", and the like (if existent) are intended to distinguish between similar objects but do not necessarily indicate a specific order or sequence.

Finally, it should be noted that the foregoing embodiments are merely intended to describe the technical solutions in embodiments of this application, but not to limit this application. Although embodiments of this application are described in detail with reference to the foregoing embodiments, persons of ordinary skill in the art should understand that they may still make modifications to the technical solutions described in the foregoing embodiments or make equivalent replacements to some or all technical features thereof, without departing from the scope of the technical solutions in embodiments of this application.

## Claims

1. A foldable device, comprising a housing assembly (10) and a flexible display (600) disposed on a surface of the housing assembly (10), wherein
the flexible display (600) comprises a support layer (610) and a cover layer (620), the support layer (610) is located on a side, facing the housing assembly (10), of the flexible display (600), and the cover layer (620) is located on a side, facing away from the housing assembly (10), of the flexible display (600);
the housing assembly (10) comprises a first mechanical part (100), a second mechanical part (200), a third mechanical part (300), a first hinge mechanism (400), and a second hinge mechanism (500);
the first mechanical part (100) comprises a first end (110) and a second end (120) that are opposite to each other, the first end (110) is rotatably connected to the second mechanical part (200) through the first hinge mechanism (400), and the second end (120) is rotatably connected to the third mechanical part (300) through the second hinge mechanism (500);
the first mechanical part (100) comprises a first side surface (130), the first side surface (130) is located on a side in a thickness direction of the first mechanical part (100), and the first side surface (130) comprises a first region (131) and a second region (132); and
the second mechanical part (200) and the first region (131) are fastened to the support layer (610) through a first fastening structure (710), and the third mechanical part (300) and the second region (132) are fastened to the cover layer (620) through a second fastening structure (720).

2. The foldable device according to claim 1, wherein when the foldable device is in a folded state, the second mechanical part (200) and the third mechanical part (300) are located on a same side in the thickness direction of the first mechanical part (100).

3. The foldable device according to claim 2, wherein when the foldable device is in the folded state, the second mechanical part (200) and the third mechanical part (300) are located on a side in a first direction of the first mechanical part (100), wherein
the first direction is a direction in which the first side surface (130) faces the flexible display (600) along the thickness direction of the first mechanical part (100).

4. The foldable device according to claim 2, wherein when the foldable device is in the folded state, the second mechanical part (200) and the third mechanical part (300) are located on a side in a second direction of the first mechanical part (100), wherein
the first mechanical part (100) further comprises a second side surface (140) opposite to the first side surface (130), and the second direction is a direction in which the second side surface (140) faces away from the flexible display (600) along the thickness direction of the first mechanical part (100).

5. The foldable device according to any one of claims 1 to 3, wherein when the foldable device is in the folded state, the second mechanical part (200) is located on the side in the first direction of the first mechanical part (100);
the second mechanical part (200) comprises a third end (210) and a fourth end (220) that are opposite to each other, the first end (110) is rotatably connected to the third end (210) through the first hinge mechanism (400), and one end of the flexible display (600) is located between the third end (210) and the fourth end (220); and
when the foldable device is in an unfolded state, a first spacing (L1) exists between the cover layer (620) and the fourth end (220); or
when the foldable device is in the folded state, a second spacing (L2) exists between the cover layer (620) and the fourth end (220), wherein
the first spacing (L1) is greater than the second spacing (L2).

6. The foldable device according to claim 1, 2, or 4, wherein when the foldable device is in the folded state, the third mechanical part (300) is located on the side in the second direction of the first mechanical part (100);
the third mechanical part (300) comprises a fifth end (310) and a sixth end (320) that are opposite to each other, the second end (120) is rotatably connected to the fifth end (310) through the second hinge mechanism (500), and one end of the flexible display (600) is located between the fifth end (310) and the sixth end (320); and
when the foldable device is in an unfolded state, a third spacing (L3) exists between the support layer (610) and the sixth end (320); or
when the foldable device is in the folded state, a fourth spacing (L4) exists between the support layer (610) and the sixth end (320), wherein
the third spacing (L3) is greater than the fourth spacing (L4).

7. The foldable device according to any one of claims 1 to 6, wherein the flexible display (600) further comprises a display layer (630) located between the cover layer (620) and the support layer (610), wherein
the cover layer (620) comprises a fastening region (622) protruding from an outer edge of the display layer (630), and the second fastening structure (720) is located in the fastening region (622).

8. The foldable device according to any one of claims 1 to 7, wherein the first hinge mechanism (400) is fastened to the support layer (610) through the first fastening structure (710).

9. The foldable device according to any one of claims 1 to 8, wherein the second hinge mechanism (500) is fastened to the cover layer (620) through the second fastening structure (720).

10. The foldable device according to any one of claims 1 to 9, wherein both the first fastening structure (710) and the second fastening structure (720) are bonding structures; and
the second mechanical part (200) and the first region (131) are bonded and fastened to the support layer (610) through the first fastening structure (710), and the third mechanical part (300) and the second region (132) are bonded and fastened to the cover layer (620) through the second fastening structure (720).

11. A foldable device, comprising a housing assembly (10) and a flexible display (600) disposed on a surface of the housing assembly (10), wherein
the flexible display (600) comprises a support layer (610) and a cover layer (620), the support layer (610) is located on a side, facing the housing assembly (10), of the flexible display (600), and the cover layer (620) is located on a side, facing away from the housing assembly (10), of the flexible display (600);
the housing assembly (10) comprises a first mechanical part (100), a second mechanical part (200), a third mechanical part (300), a first hinge mechanism (400), and a second hinge mechanism (500);
the first mechanical part (100) comprises a first end (110) and a second end (120) that are opposite to each other, the first end (110) is rotatably connected to the second mechanical part (200) through the first hinge mechanism (400), and the second end (120) is rotatably connected to the third mechanical part (300) through the second hinge mechanism (500);
the first mechanical part (100) comprises a first side surface (130) and a second side surface (140), the first side surface (130) and the second side surface (140) are separately located on two sides in a thickness direction of the first mechanical part (100), and when the foldable device is in a folded state, the second mechanical part (200) is located on a side in a second direction of the first mechanical part (100), and the third mechanical part (300) is located on a side in a first direction of the first mechanical part (100), wherein the first direction is a direction in which the first side surface (130) faces the flexible display (600) along the thickness direction of the first mechanical part (100), and the second direction is a direction in which the second side surface (140) faces away from the flexible display (600) along the thickness direction of the first mechanical part (100); and
one of the support layer (610) and the cover layer (620) is fastened to the first side surface (130), the second mechanical part (200), and the third mechanical part (300).

12. The foldable device according to claim 11, wherein the first side surface (130), the second mechanical part (200), and the third mechanical part (300) are fastened to the support layer (610) through a first fastening structure (710).

13. The foldable device according to claim 12, wherein at least one of the first hinge mechanism (400) and the second hinge mechanism (500) is fastened to the support layer (610) through the first fastening structure (710).

14. The foldable device according to claim 12 or 13, wherein the third mechanical part (300) comprises a fifth end (310) and a sixth end (320) that are opposite to each other, the second end (120) is rotatably connected to the fifth end (310) through the second hinge mechanism (500), and one end of the flexible display (600) is located between the fifth end (310) and the sixth end (320); and
when the foldable device is in an unfolded state, a fifth spacing (L5) exists between the cover layer (620) and the sixth end (320); or
when the foldable device is in the folded state, a sixth spacing (L6) exists between the cover layer (620) and the sixth end (320), wherein
the fifth spacing (L5) is greater than the sixth spacing (L6).

15. The foldable device according to claim 11, wherein the first side surface (130), the second mechanical part (200), and the third mechanical part (300) are fastened to the cover layer (620) through a second fastening structure (720).

16. The foldable device according to claim 15, wherein at least one of the first hinge mechanism (400) and the second hinge mechanism (500) is fastened to the cover layer (620) through the second fastening structure (720).

17. The foldable device according to claim 15 or 16, wherein the second mechanical part (200) comprises a third end (210) and a fourth end (220) that are opposite to each other, the first end (110) is rotatably connected to the third end (210) through the first hinge mechanism (400), and one end of the flexible display (600) is located between the third end (210) and the fourth end (220); and
when the foldable device is in an unfolded state, a seventh spacing (L7) exists between the support layer (610) and the fourth end (220); or
when the foldable device is in the folded state, an eighth spacing (L8) exists between the support layer (610) and the fourth end (220), wherein
the seventh spacing (L7) is greater than the eighth spacing (L8).

18. The foldable device according to any one of claims 11 to 17, wherein one of the support layer (610) and the cover layer (620) is bonded and fastened to the first side surface (130), the second mechanical part (200), and the third mechanical part (300) through a bonding structure.
